# EUROPEAN PATENT SPECIFICATION

(11) **EP 2 627 803 B1**
(45) Date of publication and mention of the grant of the patent: **22.11.2017**
(21) Application number: 11773121.6
(22) Date of filing: 13.10.2011
(51) Int. Cl.: H01L 21/04, H01L 29/16, C30B 25/18, C30B 29/36, C30B 33/06

(54) **HETEROGROWTH**
HETEROWACHSTUM
HÉTÉRO-CROISSANCE

(30) Priority: 13.10.2010 GB 201017279
(43) Date of publication of application: 21.08.2013
(73) Proprietor: The University Of Warwick, Coventry CV4 8UW (GB)
(72) Inventor: WARD, Peter, Peterborough Cambridgeshire PE8 5QJ (GB)
(74) Representative: Iqbal, Md Mash-Hud
(86) International application number: PCT/GB2011/051981
(87) International publication number: WO 2012/049510

(56) References cited:
- EP-A1- 2 100 989
- WO-A1-2010/113685
- PEREZ-TOMAS A ET AL: "Si/SiC bonded wafer: a route to carbon free SiO2 on SiC", APPLIED PHYSICS LETTERS AMERICAN INSTITUTE OF PHYSICS USA, vol. 94, no. 10, 9 March 2009 (2009-03-09) , XP002665648, ISSN: 0003-6951

## Description

### Field of the Invention

The present invention relates to heterogrowth particularly, but not exclusively to a silicon/silicon carbide heterogrowth.

### Background

Silicon carbide is a promising material for future power electronics applications because it can sustain much higher voltages than silicon and has a thermal conductivity similar to copper.

Silicon carbide exists in several different crystal forms (or "polytypes") depending on the sequence in which bilayers of silicon and carbon stack.

The most commonly-used polytype of silicon carbide is four-step hexagonal stacking sequence silicon carbide (4H-SiC) because it is possible to grow this in single crystal form and produce wafers of the semiconductor material. However, these crystals are produced by physical vapour transport (PVT) process in which a powder of silicon carbide is sublimed at about 2,200 °C producing a vapour which travels and then condenses on a seed crystal. This process is very energy intensive and so silicon carbide wafers are much more expensive to produce than silicon wafers.

Another polytype of silicon carbide, 3-step cubic silicon carbide (3C-SiC), can in principle be grown epitaxially on silicon wafers because they share a cubic crystal form. In this case, a layer of silicon carbide for device fabrication could be realised more cheaply than fabricating a 4H-SiC wafer. However, there are two significant challenges to growing a layer of 3-step cubic silicon carbide on silicon, i.e. 3C-SiC/Si heterogrowth.

Firstly, there is a lattice mismatch between 3-step cubic silicon carbide and the silicon wafer seed.

Secondly, silicon carbide and silicon have different coefficients of thermal expansion. When a layer of silicon carbide is grown on silicon at elevated temperatures and then cooled to room temperature, the silicon carbide contracts at a faster rate than silicon, thus the resulting structure bows.

Attempts have been made to address the problem of cracking in layers of silicon carbide deposited on single-crystal (or "monocrystalline") silicon wafers. WO 03069657 A describes growing silicon carbide on a single-crystal silicon-germanium substrate having a germanium content of between 5 and 20%.

EP2100989 relates to a method for preparing a substrate having monocrystalline film. Perez-Tomas et al "Si/SiC bonded wafer: a route to carbon free SiO2 on SiC"; Applied Physics Letters, vol 94, 2009; relates to a Si/SiC bonded wafer. EP2415909 relates to a bonded substrate having a single crystalline wafer.

### Summary

Aspects and preferred features are set out in the accompanying claims.
It is disclosed herein a method comprising bonding a wafer and a wafer-like carrier so as to form a composite wafer having a surface, wherein the wafer comprises silicon and has a monocrystalline silicon surface region and the carrier comprises silicon carbide and wherein the wafer and carrier are bonded such that the monocrystalline silicon surface region is at the surface of the composite wafer.

Thus, when the composite wafer is heated to a suitably high temperature for silicon carbide heterogrowth (but below the melting point of silicon), the silicon carbide carrier stretches the silicon in the wafer. When a layer of monocrystalline or polycrystalline silicon carbide semiconductor is grown on the monocrystalline silicon surface region and the resulting heterostructure is cooled, then the difference in rate of contraction between the silicon carbide layer and silicon is reduced which can help avoid or at least reduce wafer bow.

The method may further comprise heating the composite wafer and growing a layer of silicon carbide on the monocrystalline silicon surface region of the wafer.

We disclose herein a method comprising heating a composite wafer which comprises a wafer comprising silicon and having a monocrystalline silicon surface region and a wafer-like carrier comprising silicon carbide and growing a silicon carbide layer on the monocrystalline silicon surface region of the wafer.

Growing the silicon carbide layer may comprise growing an epitaxial layer of monocrystalline silicon carbide or a layer of polycrystalline silicon carbide.

The layer may comprise a layer of 3-step cubic silicon carbide (3H-SiC). The layer may have a thickness of at least 0.5µm.

The wafer may comprise a monocrystalline silicon wafer, i.e. not just the surface region is monocrystalline, but the wafer is monocrystalline throughout. However, the wafer may comprise silicon-on-insulator wafer comprising a monocrystalline layer of silicon disposed on a silicon dioxide layer which is turn is disposed on a (monocrystalline) silicon substrate. The monocrystalline silicon surface region may be patterned. The monocrystalline silicon surface region may be an epitaxial layer.

The term "silicon wafer" is intended to exclude a silicon-germanium wafer. The term "silicon-on-insulator wafer" is intended to exclude a silicon-germanium-on-insulator (SGOI) wafer.

The wafer may have a diameter of at least 2 inches (50.8 mm) or of at least 100 mm. The wafer may have a thickness of at least 250 µm for a wafer diameter of about 50 mm or less, a thickness of at least 500 µm for a wafer diameter of about 100 mm or less or a thickness of at least 650 µm for a wafer diameter of about 150 mm or more. Thus, the wafer can be self-supporting if the carrier is removed.

The carrier may be amorphous and/or polycrystalline. Thus, cheap silicon carbide substrates, for example "dummy wafers" or "blanks", can be used. Such silicon carbide substrates can be made by converting graphite into silicon carbide. The carrier may monocrystalline

Bonding may include directly bonding the wafer and carrier without an intermediate layer or indirectly bonding the wafer and carrier with one or more intermediate layer.

A surface of the carrier may have a surface roughness of less than or equal to 10 Å or less than or equal to 5 Å. Thus, the surface of the carrier may be sufficiently smooth for wafer bonding. A surface of the carrier may be plasma activated. The wafer may have another surface, opposite the surface which may have a surface roughness of less than or equal to 10 Å or less than or equal to 5 Å.

The diameter of the carrier may be greater than or equal to the diameter of the wafer. The thickness of the carrier may at least 0.8 times or 0.9 times the thickness of the wafer. The carrier may be about the same thickness or thicker than the wafer.

The method may further comprise, after growing a layer of silicon carbide on the monocrystalline silicon, delaminating the wafer and the carrier.

We disclose herein a composite wafer comprising a wafer comprising silicon and having a monocrystalline silicon surface region and a carrier comprising silicon carbide, wherein the composite wafer has a surface and the monocrystalline silicon surface region is at the surface of the composite wafer. The wafer comprises a monocrystalline silicon wafer and the carrier may be amorphous and/or polycrystalline.

In one embodiment there is provided a semiconductor structure comprising the composite wafer and a layer comprising silicon carbide disposed on the monocrystalline silicon surface region of the wafer.

The layer may comprise a layer of 3 step cubic silicon carbide. The layer may be monocrystalline or polycrystalline. The layer may have a thickness of at least 0.5 µm.

In one embodiment there is provided a semiconductor heterostructure comprising a wafer comprising silicon and having a monocrystalline silicon surface region and a silicon carbide layer disposed on the monocrystalline silicon surface region of the wafer, wherein the semiconductor structure is not bowed.

The wafer may comprise a silicon wafer. The silicon carbide layer may have a thickness of at least 0.5 µm.

The semiconductor heterostructure may comprise a region of monocrystalline or polycrystalline silicon carbide disposed on a monocrystalline silicon substrate. The silicon carbide region is preferably not bowed and/or not cracked.

It is disclosed herein a method comprising bonding a wafer and a wafer-like carrier so as to form a composite wafer have a surface, wherein the wafer comprises a first material which is a semiconductor material and wherein the wafer has a monocrystalline semiconductor surface region and the carrier comprises a second, different material, wherein the wafer and the carrier are bonded such that the monocrystalline semiconductor surface region is at the surface of the composite wafer. The second material may be a semiconductor material.

It is disclosed herein a method comprising heating a composite wafer which comprises a wafer comprising a first material which is a semiconductor material and having a monocrystalline semiconductor surface region and a carrier comprising a second, different material and which does not have a monocrystalline semiconductor surface region and growing a layer on the monocrystalline semiconductor surface region, the layer comprising a third material which is a semiconductor material and which is different from the first material. The second material may be a semiconductor material. The third material may be the same material as the second material or may be a different material having the same or similar coefficient of thermal expansion. The layer may be monocrystalline or polycrystalline.

Thus, growth of other materials, such as gallium nitride, can benefit from use of a composite wafer.

It is disclosed herein a semiconductor structure comprising a composite wafer which comprises a wafer comprising a first material which is semiconductor material and having a monocrystalline semiconductor surface region and a carrier comprising a second, different material which does not have a monocrystalline semiconductor surface region and a layer disposed on the monocrystalline surface region, wherein the layer comprises a third material which is a semiconducting material and which is different from the first material. The second material may be a semiconductor material. The third material may be the same as the second material or may be a different material having the same or similar coefficient of thermal expansion. The layer may be monocrystalline or polycrystalline.

It is disclosed herein a semiconductor heterostructure comprising a wafer comprising a first semiconductor material having a first coefficient of thermal expansion and having a monocrystalline semiconductor surface region and a layer comprising a second, different semiconductor material disposed on the monocrystalline surface region of the first wafer, wherein the second semiconductor material has a second, different coefficient of thermal expansion and a minimum temperature of growth, wherein the difference between the first and second coefficients of thermal expansion and the difference between the minimum temperature of growth, for example for polycrystalline or monocrystalline growth, and room temperature are sufficiently high to cause bowing and wherein the semiconductor structure is not bowed.

It is disclosed herein a semiconductor device comprising a monocrystalline substrate comprising first semiconductor material and a monocrystalline or polycrystalline region comprising a second, different semiconductor material disposed on the substrate, wherein first semiconductor material has a first coefficient of thermal expansion and the second semiconductor material has a second, different coefficient of thermal expansion and a minimum temperature of growth and wherein the difference between the first and second coefficients of thermal expansion and the difference between the minimum temperature of growth and room temperature are sufficiently high to cause bowing after a layer of the first material is grown at or above the minimum temperature of growth and then cooled to room temperature.

### Brief Description of the Drawings

Certain embodiments of the present invention will now be described, by way of example, with reference to the accompanying drawings, in which:
Figures 1a to 1e illustrates stages during a first process of heteroepitaxy;
Figures 2a to 2f illustrate stages during a second process of heteroepitaxy;
Figure 3 is a flow diagram of a method of fabrication employing the second process of heteroepitaxy shown in Figures 2a to 2f
Figure 4 shows a heterostructure without a carrier; and
Figure 5 schematically illustrates a semiconductor device.

### Detailed Description

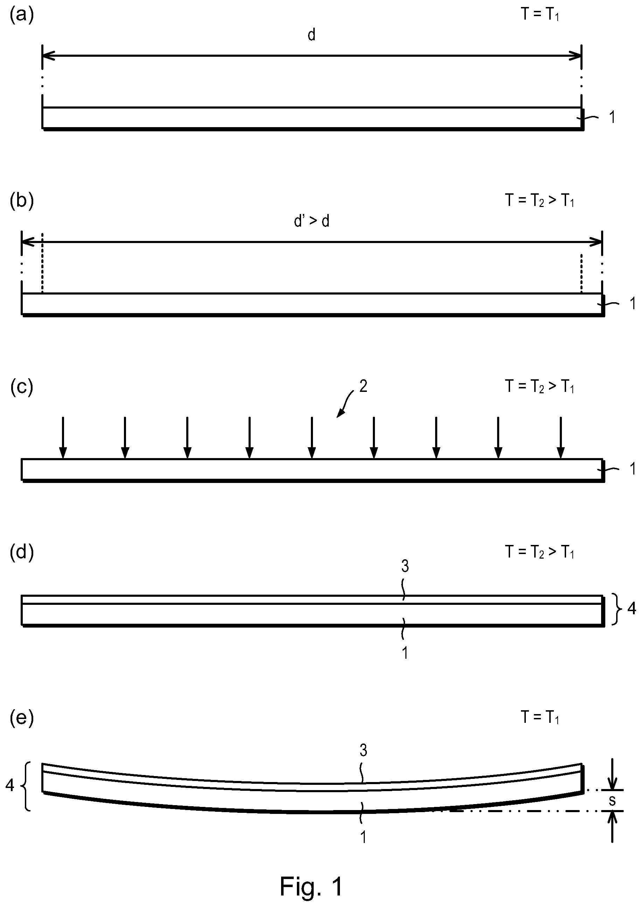

Before describing embodiments of the present invention, a silicon carbide/silicon heteroepitaxy process will be described with reference to Figures 1a to 1e which may be useful for understanding the present invention.

Figure 1a shows a monocrystalline silicon wafer 1 at a room temperature (about 25 °C). The silicon wafer 1 serves as a seed wafer on which a layer of three-step cubic silicon carbide (3C - SiC) can be epitaxially grown. The silicon wafer 1 has a diameter, d.

The silicon wafer 1 is placed in a silicon carbide epitaxial reactor (not shown) and is heated to about 1350 °C. As shown (in highly schematic form) in Figure 1b, the silicon wafer 1 expands when heated. The heated wafer has a diameter, d', greater than diameter, d, of the wafer at room temperature.

Referring to Figure 1c, the heated silicon wafer 1 is exposed to a vapour 2 of silicon and carbon reactive species in a chemical vapour deposition (CVD) process. The vapour 2 adsorbs on the silicon wafer 1 forming three-step cubic silicon carbide. Although, the lattice constants of silicon carbide and silicon normally differ, an epitaxial layer 3 of three-step cubic silicon carbide grows on the silicon substrate 1 matching the lattice constant of silicon by means of lattice dislocations (not shown) and forming a composite structure 4, as shown in Figure Id.

However, as shown in Figure 1e, when the composite structure 4 is removed from the reactor and allowed to cool, the silicon carbide epitaxial layer 3 shrinks at a faster rate than the underlying silicon wafer 3 and so the structure 4 bows.

For a silicon wafer 1 having a diameter of 150 mm, the edges of the wafer can be raised by a distance, s, relative to the centre of the wafer by about 10 mm.

The present invention seeks to address this problem.

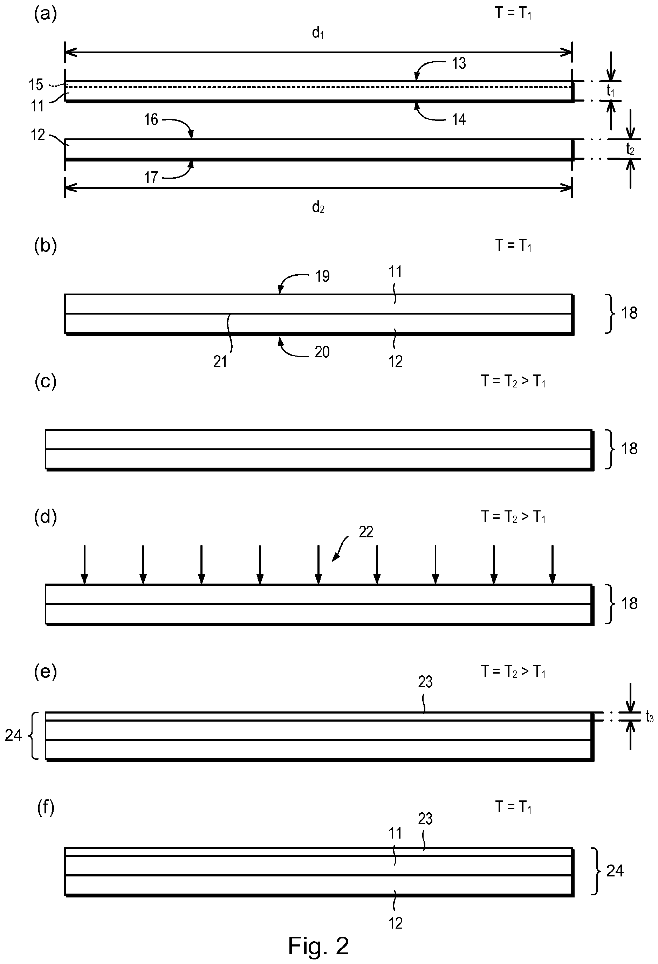

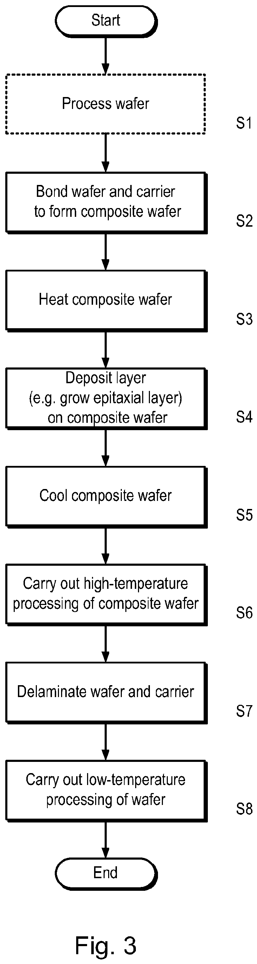

Referring to Figures 2a to 2f and also to Figure 3, an embodiment of a method of heteroepitaxy, i.e. heterogrowth of a monocrystalline semiconductor layer, in accordance with the present invention will be described.

Figure 2a shows a monocrystalline silicon wafer 11 and a polycrystalline silicon carbide substrate 12 at a room temperature.

The silicon wafer 11 has an off-axis, [111] crystal orientation and is polished on both sides 13, 14. The sides 13, 14 may also be referred to as "surfaces" or "faces". Other crystal orientations may be used, such as [100]. The silicon wafer 11 has a thickness, t₁, and a diameter, d₁. In this example, t₁ = 200 µm and d₁ = 100 mm. The silicon wafer 11 has a wafer bow less than 25 µm and so can be considered to have substantially no bow.

The silicon wafer 11 serves as a seed wafer on which a layer of monocrystalline three-step cubic silicon carbide can be epitaxially grown on a first side 13 of the wafer 11 (hereinafter referred to as the "upper surface") on a monocrystalline silicon surface region 15. In some embodiments, silicon-on-insulator may be used and so the monocrystalline silicon surface region can take the form of a monocrystalline silicon layer, for example having a thickness of about 50 to 200 nm, disposed on a layer of silicon dioxide. However, other wafers having different layer structures, but which is mostly or predominantly comprised or made up of silicon can be used. For example, a wafer which mostly comprises silicon but which has one or a few layers of non-silicon material embedded in it may be used. Thus, the total thickness (or volume) of non-silicon material used in layers or regions of the wafer may make up no more about 1%, 0.1% or even 0.01 % of the wafer.

The silicon carbide carrier 12 is wafer-like in size and appearance, and is polished on both sides 16, 17 and is used as a carrier for the silicon wafer 11. The silicon carbide carrier 12 has a thickness, t₂, and a diameter, d₂. In this example, t₂ = 500 µm and d₂ = 100 mm.

In this example, a polycrystalline carrier 12 is used. However, a monocrystalline carrier can be used. However, unpolished polycrystalline silicon carbide substrates are cheap and are often used as furnace dummy wafers (or "blanks") in silicon processing. Unpolished polycrystalline silicon carbide substrates can be produced by cutting slices from a bar of graphite, chemically converting the graphite into a porous form of silicon carbide and then depositing a 75 µm layer of silicon carbide on both faces using chemical vapour deposition. Suitable unpolished silicon carbide substrates are marketed under the name SUPERSiC® by Poco Graphite, Inc., Texas, USA. The surface roughness of unpolished silicon carbide substrates is in the region of 1 µm.

The unpolished silicon carbide substrate is polished using a pure mechanical polishing process using a chemically-inert polishing slurry (not shown) so as to provide a sufficiently flat surface 16 for wafer bonding. Some forms of chemical mechanical polishing may not be appropriate for a non-crystalline surface since they may pull grains from the surface of the substrate. The upper surface 16 has a surface roughness (Ra) of less than or equal to 5 Å. The lower surface 17 can also be polished or may be treated in other ways, for example by etching grooves or other structures, so as to avoid wafer bow. In this case, the lower surface has a surface roughness of less than or equal to 100 Å. The silicon carbide wafer 12 has substantially no bow, having wafer bow less than 50 µm. Surface roughness can be tested using atomic force microscopy.

Before heteroepitaxy, the silicon wafer 11 may be processed, for example, by patterning and etching the upper surface 13 and/or the lower surface 14 (step S1).

For example, the lower surface 14 may be patterned using inverted pyramids or other structure so as to help dislocations arising from lattice mismatch to merge, as described, for example, in "3C-SiC Heteroepitaxial Growth on Inverted Silicon Pyramids (ISP)", by G. D'Arrigo et al., Materials Science Forum, volumes 645 to 648, pages 135-138 (2010).

Referring to Figure 2b, the silicon wafer 11 and (polished) silicon carbide carrier 12 are bonded to form a composite wafer 18 (step S2). The wafer bonding process includes subjecting the surface 16 of the silicon carbide carrier 12 to plasma treatment using argon prior, heating the wafers 11, 12 to 500 °C after bringing the wafer 11 and carrier 12 into contact.

The upper surface 13 of the silicon wafer 11 forms a first (exterior) surface 19 of the composite wafer 13 (herein referred to as the "upper surface" of the composite wafer 13). The lower surface 17 of the carrier 12 forms a second exterior surface 20 of the composite wafer 13 (herein referred to as the "lower surface" of the composite wafer 13). The lower surface 14 of the silicon wafer 11 and the upper surface 16 of the silicon carbide carrier 12 form an (interior) interface 21. In embodiments which use intermediate layers for wafer bonding, more than one interior interface can be formed.

The composite wafer 18 is placed into a silicon carbide epitaxial reactor (not shown), such as an ACiS M10 marketed by LPE S.p.A., Baranzate, Italy. The reactor chamber (not shown) is subjected to a high-vacuum bake out at about 500 °C and is re-filled with hydrogen at about 100 mbar. The composite wafer 18 is heated via inductive heating of a susceptor (not shown). The surface 13 of the silicon wafer 11 is protected by carbonization using C₂H₄ at 1170 °C. As shown (in highly schematic form) in Figure 2c, the composite wafer 18 expands (step S3).

Referring to Figures 2d and 2e, silicon carbide 22 is grown using SiHCl₃ and C₂H₄ at 1370 °C resulting in an epitaxial layer 23 of monocrystalline silicon carbide and a structure 24 (step S4). In some embodiments, silicon carbide 22 may be grown under other conditions, e.g. lower temperature, resulting in a non- epitaxial layer 20 of polycrystalline silicon carbide. The silicon carbide layer 23 may be undoped or lightly-doped (e.g. with a background doping of the order of 10¹⁴ cm⁻³) or doped n-type or p-type with nitrogen (N) or aluminium (Al) respectively.

Thus, the composite wafer 18 is heated to a temperature below the melting point of silicon (i.e. 1410 °C) and significantly below the melting point of silicon carbide (i.e. about 2200 °C). Thus, the silicon wafer 11 becomes plastic and so can be stretched more easily by the underlying silicon carbide carrier 12.

The reactor chamber (now shown) is purged and temperature is ramped down (step S5).

As shown in Figure 2f, when the structure 24 is cooled, it does not bow.

The silicon carbide layer 23 can be processed to form semiconductor devices, for example, power electronic devices or nano electro-mechanical systems (NEMS) devices.

Processing may include high-temperature processing steps such as gate oxidation, implant annealing etc. (step S6).

After completing the high-temperature processing steps, the silicon wafer 11 and silicon carbide carrier 12 may be delaminated, for example, by cleaving the interface 21 between the wafer 11 and the carrier 12, so as to leave the silicon wafer 11 (step S7).

Processing of the wafer 11 can continue and may include steps such as thin film deposition, lithography, dry etching and so on (step S8).

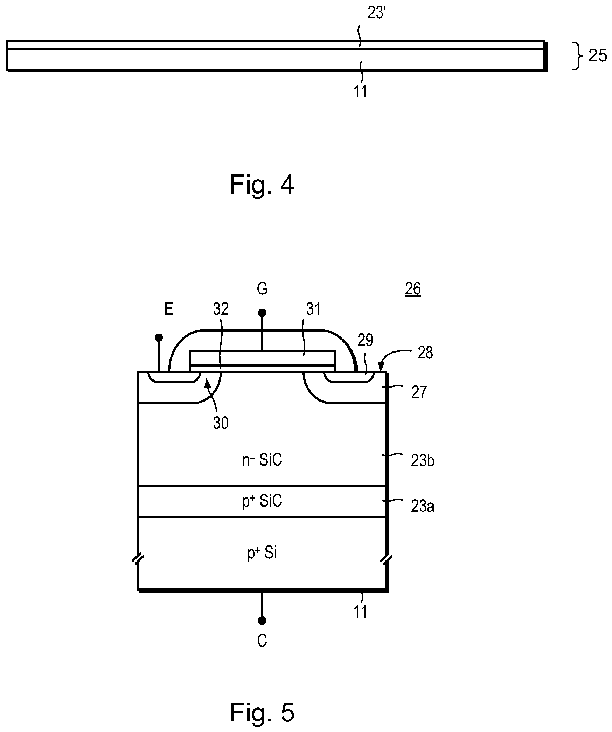

Figure 4 shows a processed structure 25 having a processed silicon carbide layer 23'. As shown in Figure 4, the silicon carbide carrier 12 has been removed and so the silicon wafer 11 is free standing.

Referring to Figure 5, an example of a semiconductor device 26 in the form of a insulated gate bipolar transistor (IGBT) is shown.

The device 26 has first and second 3-step cubic silicon carbide epitaxial layers 23a, 23b including a heavily-doped p-type layer 23a which is supported on a p-type silicon substrate 11 and which provides a p-type collector, and a lightly-doped n-type layer 23b which provides a drift region and which is supported on the p-type silicon carbide layer 23a. P-type wells 27 at the surface 28 of the epitaxial layer 23 provide body regions 27. N-type wells 29 within the p-type wells 27 provide contact regions. A channel 30 is formed beneath a gate 31 which separated using a gate dielectric layer 32.

The IGBT shown in Figure 5 is able to support much greater breakdown voltages due to the use of silicon carbide in the epitaxial drift region 23.

In a test sample using a composite wafer as hereinbefore described, a layer of silicon carbide having a thickness of 1.4 µm can be grown and the structure cooled to room temperature without bow. In a comparative sample using a silicon wafer (i.e. without a composite wafer), a layer of silicon carbide having a thickness of 1.4 µm is grown, but on cooling to room temperature, the structure bows by over 300 µm.

In another test sample using a composite wafer as hereinbefore described, a layer of silicon carbide having a thickness, t₃, of 4.4 µm is grown and the structure cooled to room temperature without any bow. In a comparative sample using a silicon wafer (i.e. without a composite wafer), the same thickness of silicon carbide is grown, but on cooling to room temperature, the structure bows by several millimetres and later breaks.

Thus, using a composite wafer helps to minimise and even avoid bow and can be used to grow an epitaxial layer of silicon carbide on silicon having a thickness of over 4 µm without any bow in the resulting structure when cooled.

It will be appreciated that many modifications may be made to the embodiments hereinbefore described.

Different wafer diameters and thicknesses can be used. For example, wafers having diameters of 150 mm, 200 mm, 300 mm or more can be used.

The growth conditions, for instance temperature, pressure and/or precursors, can be varied and optimised.

A material other than silicon can be used for the seed wafer. Thus, wafers made up of (or predominantly of) an inorganic semiconductor can be used.

A material other than silicon carbide can be used for the carrier and be grown. For example, other inorganic semiconductor materials can be used. Moreover, different materials having the same or sufficiently similar coefficient of thermal expansion can be used for the carrier and grown layer. For example, the seed wafer can be silicon, the carrier can comprise germanium (Ge) and the grown layer may comprise gallium nitride (GaN). The carrier need not be made from a semiconductor material provided that the material properties (e.g. thermal expansion coefficient and melting point) suitably match those of the layer being grown and can be suitably bonded to wafer. Thus, the carrier may be formed from a metal, metal alloy or dielectric material.

Wafer bonding may be direct, with no intermediate layer, or indirect, using an intermediate layer.

The process need not involve growing a monocrystalline layer of semiconductor material (i.e. heteroepitaxy), but can involve growing non-monocrystalline layers, e.g. polycrystalline layers of semiconductor material.

An upper surface or face of a wafer or carrier may be referred to as a "front surface", "front face", "top surface" or "top face" of the wafer or carrier. Likewise, a lower surface or face may be referred to a "back surface", "rear surface", "back face", "rear face", "bottom surface", "bottom face" of the wafer or carrier.

## Claims

1. A method comprising:
heating a composite wafer (18) which comprises a wafer (13) comprising silicon and having a monocrystalline silicon surface region (15) and a wafer-like carrier (12) comprising silicon carbide; and
growing a layer comprising silicon carbide on the monocrystalline silicon surface region, wherein the silicon carbide layer comprises a layer of 3-step cubic silicon carbide;
cooling the composite wafer having the silicon carbide layer grown thereon; and
reducing a difference in rate of contraction between the silicon carbide layer and the silicon of the wafer to reduce wafer bow.

2. A method according to claim 1, wherein:
growing the silicon carbide layer comprises growing an epitaxial layer (3) of monocrystalline silicon carbide; or
growing the silicon carbide layer (3) comprises growing a layer of polycrystalline silicon carbide.

3. A method according to claim 1 or 2, wherein:
the silicon carbide layer has a thickness of at least 0.5 µm; and/or
the monocrystalline silicon surface region is patterned; and/or
the wafer comprises a silicon wafer or a silicon-on-insulator wafer.

4. A method according to any preceding claim, wherein:
the carrier (12) is amorphous and/or polycrystalline; and/or
a surface of the carrier in contact with the wafer has a surface roughness of less than or equal to 10 Å; and/or
the diameter of the carrier is greater than or equal to the diameter of the wafer.

5. A method according to any preceding claim, wherein the thickness of the carrier is at least 0.4 times or at least 0.6 times the thickness of the wafer.

6. A method according to any one of claims 1 to 5, wherein the thickness of the carrier is no more than 1.1 or no more than 0.9 times the thickness of the wafer.

7. A method according to any preceding claim, further comprising:
after growing the layer of silicon carbide on the monocrystalline silicon surface region, delaminating the wafer and the carrier,
and optionally further comprising:
after growing the layer of silicon carbide on the monocrystalline silicon surface region and before delaminating the wafer and the carrier performing high-temperature processing of the composite wafer.

8. A method according to any preceding claim, further comprising:
processing the layer of silicon carbide to form a semiconductor device.

9. A semiconductor structure manufactured using the steps of any one of claims 1 to 8.

## Patentansprüche

1. Verfahren umfassend:
das Erhitzen eines Kompositwafers (18), der einen Wafer (13), der Silicium umfasst und eine monokristalline Siliciumoberflächenregion (15) aufweist, und einen waferähnlichen Träger (12), der Siliciumcarbid umfasst, umfasst; und
das Züchten einer Schicht, die Siliciumcarbid umfasst, auf der monokristallinen Siliciumoberflächenregion, wobei die Siliciumcarbidschicht eine Schicht kubisches Dreischicht-Siliciumcarbid umfasst;
das Kühlen des Kompositwafers, der eine darauf gezüchtete Siliciumcarbidschicht aufweist; und
das Reduzieren eines Unterschieds zwischen der Schrumpfungsrate der Siliciumcarbidschicht und derjenigen des Siliciums des Wafers, um den Waferbogen zu reduzieren.

2. Verfahren nach Anspruch 1, wobei:
das Züchten der Siliciumcarbidschicht das Züchten einer epitaxialen Schicht (3) aus monokristallinem Siliciumcarbid umfasst; oder
das Züchten der Siliciumcarbidschicht (3) das Züchten einer Schicht von polykristallinem Siliciumcarbid umfasst.

3. Verfahren nach Anspruch 1 oder 2, wobei:
die Siliciumcarbidschicht eine Dicke von mindestens 0,5 µm aufweist; und/oder
die monokristalline Siliciumoberflächenregion gemustert ist; und/oder
der Wafer einen Siliciumwafer oder einen Silicium-auf-Isolator-Wafer umfasst.

4. Verfahren nach irgendeinem vorhergehenden Anspruch, wobei:
der Träger (12) amorph und/oder polykristallin ist; und/oder
eine Oberfläche des Trägers in Kontakt mit dem Wafer eine Oberflächenrauheit von weniger als oder gleich 10 Å aufweist; und/oder
der Durchmesser des Trägers größer als oder gleich dem Durchmesser des Wafers ist.

5. Verfahren nach irgendeinem vorhergehenden Anspruch, wobei die Dicke des Trägers das mindestens 0,4-fache oder mindestens 0,6-fache der Dicke des Wafers ist.

6. Verfahren nach irgendeinem der Ansprüche 1 bis 5, wobei die Dicke des Trägers nicht mehr als das 1,1- oder nicht mehr als das 0,9-fache der Dicke des Wafers ist.

7. Verfahren nach irgendeinem vorhergehenden Anspruch, ferner Folgendes umfassend:
nach dem Züchten der Schicht Siliciumcarbid auf der monokristallinen Siliciumoberflächenregion Delaminieren des Wafers und des Trägers,
und wahlweise ferner Folgendes umfassend:
nach dem Züchten der Schicht von Siliciumcarbid auf der monokristallinen Siliciumoberflächenregion und vor dem Delaminieren des Wafers und des Trägers, Ausführen einer Hochtemperaturbearbeitung des Kompositwafers.

8. Verfahren nach irgendeinem vorhergehenden Anspruch, ferner Folgendes umfassend:
das Bearbeiten der Schicht Siliciumcarbid, um eine Halbleitervorrichtung zu bilden.

9. Halbleitergebilde, das unter Anwendung der Schritte nach einem der Ansprüche 1 bis 8 hergestellt wird.

## Revendications

1. Procédé comprenant:
le chauffage d'une galette composite (18) qui comprend une galette (13) comprenant du silicium et présentant une région de surface de silicium monocristallin (15) et un support type galette (12) comprenant du carbure de silicium; et
la croissance d'une couche comprenant du carbure de silicium sur la région de surface de silicium monocristallin, la couche de carbure de silicium comprenant une couche de carbure de silicium cubique en 3 étapes;
le refroidissement de la galette composite ayant développée dessus la couche de carbure de silicium; et
la réduction d'une différence du niveau de contraction entre la couche de carbure de silicium et le silicium de la galette pour réduire la flexion de la galette.

2. Procédé selon la revendication 1, dans lequel:
la croissance de la couche de carbure de silicium comprend la croissance d'une couche épitaxiale (3) de carbure de silicium monocristallin; ou
la croissance de la couche de carbure de silicium (3) comprend la croissance d'une couche de carbure de silicium polycristallin.

3. Procédé selon les revendications 1 ou 2, dans lequel:
la couche de carbure de silicium présente une épaisseur d'au moins 0,5 µm; et/ou
la région de surface de silicium monocristallin présente des motifs; et/ou
la galette comprend une galette de silicium ou une galette de silicium-sur-isolant.

4. Procédé selon l'une quelconque des revendications précédentes, dans lequel:
le support (12) est amorphe et/ou polycristallin; et/ou
une surface du support en contact avec la galette présente une rugosité de surface inférieure ou égale à 10 Å; et/ou
le diamètre du support est supérieur ou égal au diamètre de la galette.

5. Procédé selon l'une quelconque des revendications précédentes, dans lequel l'épaisseur du support est d'au moins 0,4 fois ou d'au moins 0,6 fois l'épaisseur de la galette.

6. Procédé selon l'une quelconque des revendications 1 à 5, dans lequel l'épaisseur du support n'est pas supérieure à 1,1 ou pas supérieure à 0,9 fois l'épaisseur de la galette.

7. Procédé selon l'une quelconque des revendications précédentes, comprenant en outre:
après la croissance de la couche de carbure de silicium sur la région de surface de silicium monocristallin, la déstratification de la galette et du support,
et optionnellement en outre comprenant:
après la croissance de la couche de carbure de silicium sur la région de surface de silicium monocristallin et avant la déstratification de la galette et du support, l'exécution d'un traitement à haute température de la galette composite.

8. Procédé selon l'une quelconque des revendications précédentes, comprenant en outre:
le traitement de la couche de carbure de silicium pour former un dispositif semiconducteur.

9. Structure semi-conductrice fabriquée en utilisant les étapes selon l'une quelconque des revendications 1 à 8.
